# FASCICULE DE BREVET EUROPEEN

(11) **EP 2 963 747 B1**
(45) Date de publication et mention de la délivrance du brevet: **24.04.2019**
(21) Numéro de dépôt: 15174468.7
(22) Date de dépôt: 30.06.2015
(51) Int. Cl.: H02B 1/052, H01H 89/06

(54) **MONTAGE D'UN SYSTÈME DE DÉMARRAGE SUR UNE PLURALITÉ DE RAILS DE FIXATION**
MONTAGE EINES STARTSYSTEMS AUF EINER VIELZAHL VON BEFESTIGUNGSSCHIENEN
MOUNTING OF A STARTER SYSTEM ON A PLURALITY OF FIXING RAILS

(30) Priorité: 03.07.2014 FR 1456361
(43) Date de publication de la demande: 06.01.2016
(73) Titulaire: ABB Schweiz AG, 5400 Baden (CH)
(72) Inventeur: NGUYEN, Eric, 42000 SAINT ETIENNE (FR)
(74) Mandataire: Verriest, Philippe

(56) Documents cités:
- EP-A1- 1 376 638
- EP-A1- 2 498 353
- EP-A2- 0 198 265
- WO-A2-2005/043685
- DE-A1- 3 248 124
- DE-U1- 9 202 815
- ES-A2- 2 076 075
- FR-A1- 2 837 617
- US-A1- 2011 269 339

## Description

La présente invention se rapporte au montage d'un système de démarrage sur une pluralité de rails.

Un système de démarrage est composé d'un contacteur et d'un disjoncteur. Ces appareils électriques sont généralement rapportés de manière indépendante sur des rails, permettant leur installation dans une armoire électrique. Or, ces appareils électriques sont destinés à fonctionner ensemble, il est donc plus adapté de les fixer de façon pré-assemblée sur les rails. Il est connu d'utiliser des dispositifs de fixation classiques, c'est-à-dire formés de deux éléments de montage crochetés, opposés l'un à l'autre, pour fixer les appareils électriques de manière indépendante. La fixation du système de démarrage pré-assemblé sur deux rails de fixation n'est pas possible. Les rails de fixation étant disposés sur un même premier plan et les dispositifs de fixation étant solidaires sur un même deuxième plan, il n'est pas possible d'insérer simultanément un bord d'un premier rail de fixation et un bord d'un second rail de fixation dans les logements formés par les éléments de montage crochetés.

Des systèmes de fixation sont connus du document EP 2 498 353 et des systèmes de démarrage comprenant deux appareils montés chacun sur un rail distinct sont connus des documents WO 2005/043685 et EP 1 376 638.

Il est connu d'utiliser des platines de fixation additionnelles pour rapporter le système de démarrage sur les rails de fixation, ce qui augmente l'encombrement du système, et implique un coût de fabrication plus important.

La présente invention à pour but de résoudre tout ou partie des inconvénients mentionnés ci-dessus.

Á cet effet, la présente invention concerne un système de démarrage destiné à être rapporté sur une pluralité de rails de fixation selon la revendication 1.

Grâce aux dispositions selon l'invention, l'ajout d'un dispositif de montage permet le montage d'un système de démarrage pré-assemblé sur les rails. Les boîtiers isolants conservant leurs dimensions standards, la possibilité, le cas échéant, pour les appareils électriques d'être montés indépendamment l'un de l'autre sur des rails est conservée.

Les dispositions selon l'invention permettent en outre la fixation du système de démarrage en insérant premièrement une portion d'un premier rail de fixation dans le logement formé par un élément de montage fixe, puis deuxièmement en positionnant une portion du second rail lorsque l'élément de montage mobile est maintenu en position escamotée. Enfin, l'élément de montage mobile est relâché et rappelé en position déployée et la portion du deuxième rail est ainsi retenue.

Suivant des caractéristiques optionnelles du dispositif de montage selon l'invention :
- l'élément de montage comprend une portion de préhension ;
- l'élément de blocage comprend une portion d'appui destinée à coopérer avec le premier appareil électrique ;
- l'élément élastique comprend une portion plane et une ouverture.

Selon un aspect de l'invention, le premier élément de montage et le deuxième élément de montage sont orientés de manière opposée.

Selon un aspect de l'invention, le premier élément de montage est venu de matière avec le boîtier isolant.

On entend par une direction d'extension transversale à la première direction d'extension, une direction d'extension orientée selon un angle compris entre 60° et 120° par rapport à la première direction d'extension.

De préférence, la deuxième direction d'extension est orientée selon un angle compris entre 70° et 110° par rapport à la première direction d'extension.

De préférence, la deuxième direction d'extension est orientée selon un angle compris entre 80° et 100° par rapport à la première direction d'extension.

De préférence, la deuxième direction d'extension est perpendiculaire à la première direction d'extension.

Selon un aspect de l'invention, le deuxième appareil électrique comprend un deuxième boîtier isolant, le boîtier isolant du premier appareil électrique étant appelé premier boîtier isolant, le deuxième appareil électrique comprenant, en complément de l'élément de montage du premier appareil électrique à l'état assemblé, dit élément de montage primaire un élément de montage secondaire à l'état assemblé fixe formant avec le deuxième boîtier isolant un logement secondaire en complément du logement formé par l'élément de montage primaire et le premier boîtier isolant, dit logement primaire,
le logement secondaire étant destiné à recevoir une première portion du deuxième rail de fixation dans la position relative de fixation du deuxième rail de fixation par rapport au deuxième appareil électrique à l'état assemblé,
le deuxième boîtier isolant comprenant une deuxième zone d'appui par similarité à la zone d'appui du premier boîtier isolant, dite première zone d'appui, au niveau de laquelle une deuxième portion du deuxième rail de fixation est destinée à venir en appui dans la position relative de fixation du deuxième rail de support par rapport au deuxième appareil électrique à l'état assemblé.

Selon un aspect de l'invention, l'élément de montage secondaire est venu de matière avec le deuxième boîtier isolant.

Selon un aspect de l'invention, le deuxième appareil électrique comprend un deuxième dispositif de fixation individuel, le dispositif de fixation individuel du premier appareil électrique étant dit premier dispositif de fixations, le deuxième dispositif de fixation comprenant :
- un troisième élément de montage individuel mobile entre une position escamotée et une position déployée, et formant avec le deuxième boîtier isolant un troisième logement lorsqu'il occupe la position déployée, dans lequel est destinée à venir s'insérer la première portion d'un rail de fixation dans une position relative de fixation individuelle dudit rail de fixation par rapport au second appareil électrique ;
- un quatrième élément de montage individuel fixe formant avec le deuxième boîtier isolant un quatrième logement dans lequel est destinée à venir s'insérer la deuxième portion du rail de fixation disposé dans la position relative de fixation individuelle dudit rail de fixation par rapport au second appareil électrique.

Selon un aspect de l'invention, le troisième élément de montage et le quatrième élément de montage sont orientés de manière opposée.

Selon un aspect de l'invention, le quatrième élément de montage est venu de matière avec le deuxième boîtier isolant.

Selon un aspect de l'invention, le deuxième dispositif de fixation comprend un deuxième logement d'appui, le logement d'appui du premier dispositif de fixation étant dit premier logement d'appui, le deuxième logement d'appui étant défini entre le troisième élément de montage et le quatrième élément de montage formant la deuxième zone d'appui.

Selon un aspect de l'invention, le système de démarrage comprend un dispositif de fixation du système de démarrage, destiné fixer le système de démarrage sur deux rails de fixation comprenant :
- l'élément de montage primaire destiné à coopérer avec la première portion du premier rail de fixation dans la première position relative du premier rail de fixation par rapport au premier appareil électrique ;
- l'élément de montage secondaire destiné à coopérer avec la première portion du deuxième rail de fixation dans la première position relative du deuxième rail de fixation par rapport au deuxième appareil électrique.

Selon un aspect de l'invention, le dispositif de fixation du système de démarrage comprend :
- la première zone d'appui destinée à coopérer avec la deuxième portion du premier rail de fixation dans la première position relative du premier rail de fixation par rapport au premier appareil électrique ;
- la deuxième zone d'appui du deuxième appareil électrique destinée à coopérer avec la deuxième portion du deuxième rail de fixation dans la première position relative du deuxième rail de fixation par rapport au deuxième appareil électrique.

D'autres caractéristiques et avantages de la présente invention apparaîtront à la lumière de la description qui va suivre et à l'examen des figures ci-annexées, dans lesquelles :
- la figure 1 représente un contacteur et un disjoncteur formant, à l'état assemblé, un système de démarrage ;
- la figure 2 représente un contacteur et un disjoncteur formant, à l'état assemblé, un système de démarrage rapporté sur deux rails ;
- la figure 3 représente un dispositif de montage du contacteur à l'état assemblé ;
- les figures 4a et 4b représentent un support d'un dispositif de montage ;
- les figures 5a et 5b représentent un élément de montage d'un dispositif de montage ;
- les figures 6a, 6b, 6c, 6d représentent les étapes de montage d'un dispositif de montage ;
- la figure 7 représente un contacteur sur lequel est monté un dispositif de montage ;
- les figures 8a, 8b et 8c représentent les étapes de montage d'un dispositif de montage sur un contacteur ;
- la figure 9a représente un contacteur rapporté sur un rail de manière individuelle ; et
- la figure 9b représente un disjoncteur rapporté sur un rail de manière individuelle.

Sur l'ensemble de ces figures, des références identiques ou analogues désignent des organes ou ensembles d'organes identiques ou analogues.

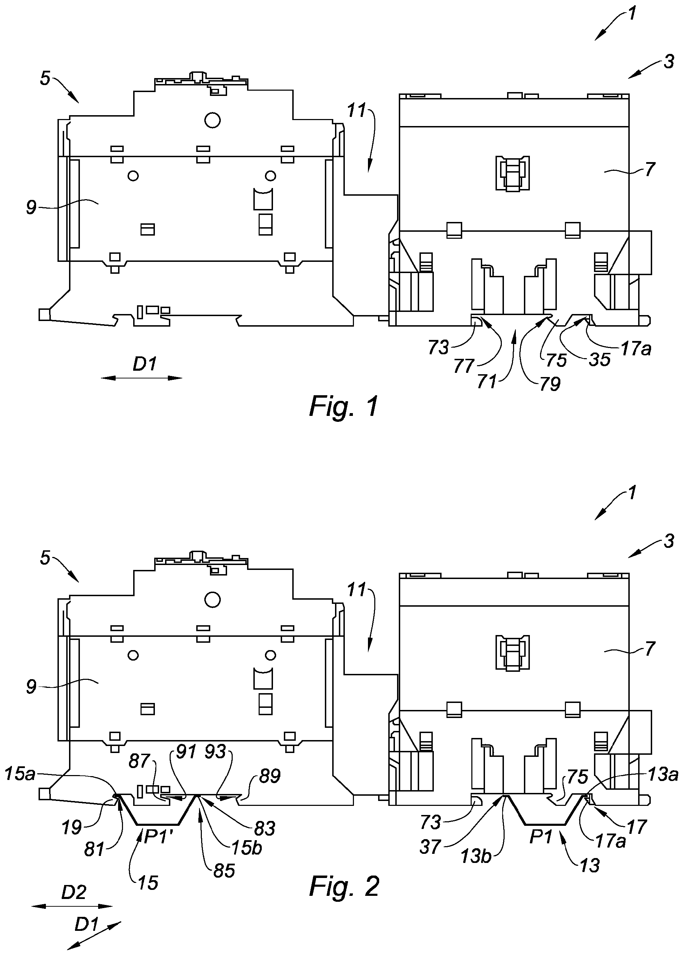

La figure 1 représente un système de démarrage 1 comprenant un contacteur 3 et un disjoncteur 5. Le contacteur 3 et le disjoncteur 5 comprennent chacun un boîtier isolant 7, 9 électriquement permettant de protéger leurs composants électriques de l'environnement extérieur. Le contacteur 3 et le disjoncteur 5 sont reliés électriquement et solidarisés par un élément de liaison 11. Le contacteur 3 et le disjoncteur 5 sont alignés selon une première direction d'extension D1.

Comme représenté en figure 2, le système de démarrage 1 est rapporté sur deux rails 13, 15 de type DIN au sein d'un boîtier électrique. Les rails 13, 15 s'étendent selon une deuxième direction d'extension D2, sensiblement perpendiculaire à la première direction d'extension D1. Les rails 13 et 15 s'étendent en regard l'un de l'autre et sont décalés l'un par rapport à l'autre. Afin d'être en mesure de fixer l'ensemble du système de démarrage 1 sur les rails 13, 15, un élément de montage 17 est rapporté sur le contacteur 3 et un élément de montage 19 est rapporté sur le disjoncteur 5. En effet, les éléments de montage 17 et 19 forment un dispositif de fixation du système de démarrage, et sont destinés à fonctionner ensemble. Lorsque le système de démarrage est fixé sur les rails 13 et 15, le rail 13 est dans une position relative de fixation P1 par rapport au contacteur 3 à l'état assemblé et le rail 15 est dans une position relative de fixation P1' par rapport au disjoncteur 5 à l'état assemblé.

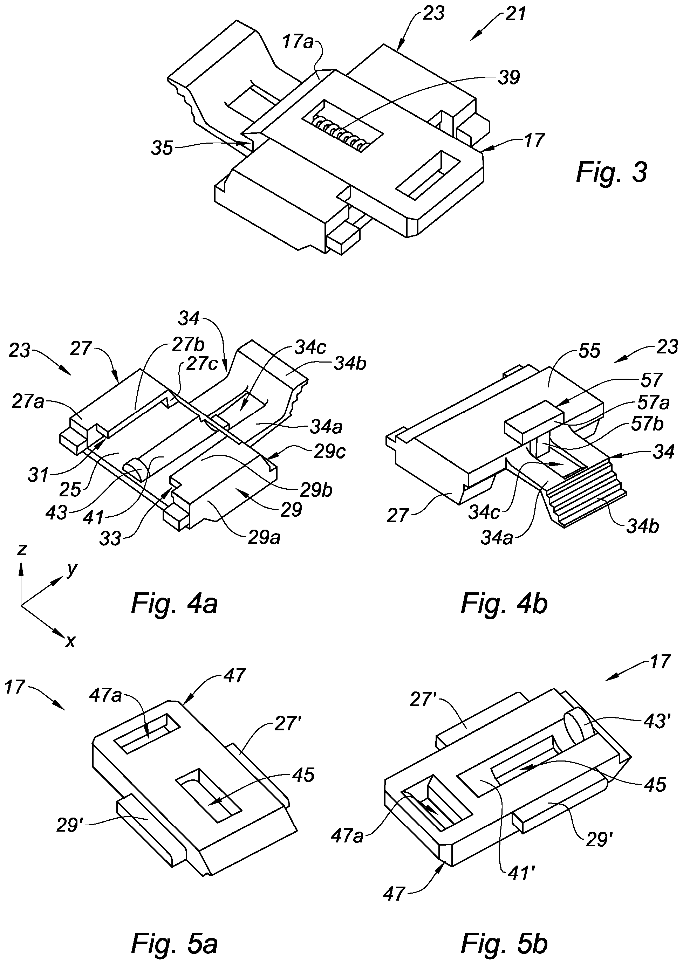

Un dispositif de montage 21 est représenté un figure 3. Le dispositif de montage 21 comprend l'élément de montage 17. Le dispositif de montage 21 comprend également un support 23 représenté en figures 4a et 4b. Le support 23 comprend une surface 25 et deux éléments de guidage 27, 29. L'élément de guidage 27 comprend un élément de butée 27a selon une direction -x, un élément de butée 27b selon une direction z et un élément de butée 27c selon une direction y. Un logement 31 est défini entre l'élément de guidage 27 et la surface 25. L'élément de guidage 29 comprend un élément de butée 29a selon une direction x, un élément de butée 29b selon une direction z et un élément de butée 29c selon une direction y. Un logement 33 est défini entre l'élément de guidage 29 et la surface 25.

L'élément de montage 17, représenté en figures 5a et 5b, est destiné à venir en appui contre la surface 25, et à s'insérer dans les logements 31 et 33. L'élément de montage 17 comprend des éléments de guidage 27' et 29'. L'élément de guidage 27' est destiné à venir en appui contre les éléments de butée 27a, 27b, 27c de l'élément de guidage 27 et l'élément de guidage 29' est destiné à venir en appui contre les éléments de butée 29a, 29b, 29c de l'élément de guidage 29.

Le support 23 comprend également un élément élastique 34, destiné à coopérer avec le boîtier isolant 7 du contacteur 3, comprenant une portion plane 34a et un élément de butée 34b et un logement 34c.

L'élément de montage 17 est mobile entre une position escamotée et une position déployée. En position déployée, représentée en figures 1, 2 et 3, un logement 35 est défini entre la portion d'extrémité 17a de l'élément de montage 17 et la portion plane 34a de l'élément élastique 34 du support 23. Un bord 13a du rail 13 est destiné à venir s'insérer dans le logement 35. L'autre bord 13b du rail 13 est destiné à venir en appui contre le boîtier isolant 7 au niveau d'une zone d'appui 37.

Un élément de rappel, ici un ressort 39 permet de rappeler l'élément de montage 17 de la position escamotée vers la position déployée. Le support 23 comprend un logement semi-circulaire 41 agencé pour accueillir le ressort 39 et une butée 43 contre laquelle une première extrémité du ressort 39 est destinée à venir en appui. L'élément de montage 17 comprend un logement semi-circulaire 41', destiné à être disposé en regard du logement semi-circulaire 41 du support 23, et agencé pour accueillir le ressort 39. L'élément de montage 17 comprend en outre une butée 43' contre laquelle est destinée à venir en appui une seconde extrémité du ressort 39. La butée 43' est destinée à être disposée en face de la butée 43 du support 23. L'élément de montage 17 comprend une ouverture d'insertion 45 du ressort 39. L'élément de montage 17 comprend un élément de préhension 47 comprenant une ouverture 47a afin de permettre le déplacement manuel de l'élément de montage 17 de la position déployée vers la position escamotée.

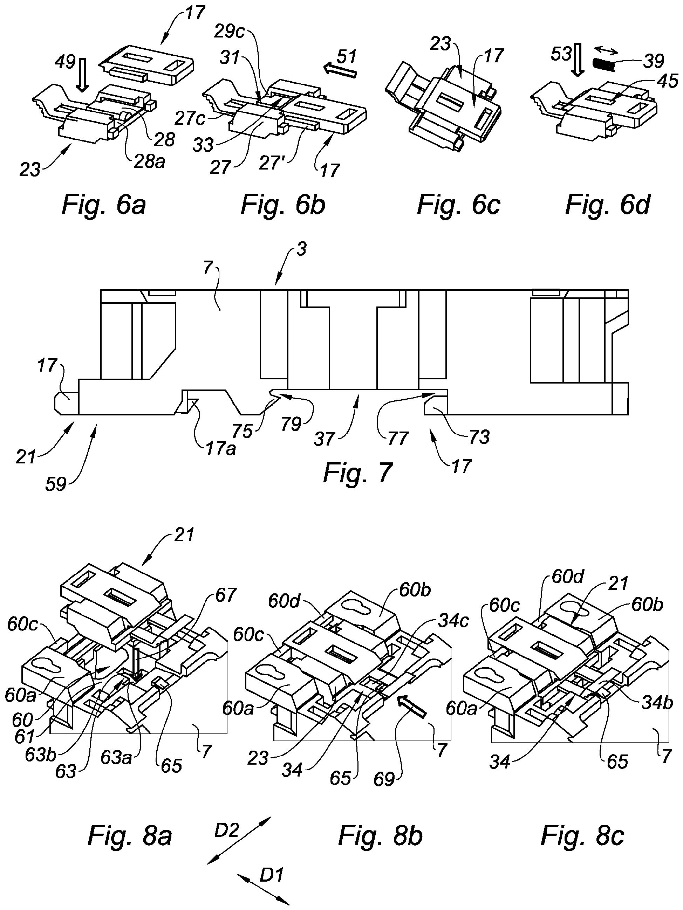

Les étapes de montage de l'élément de montage 17 sur le support 23 sont représentées en figures 6a, 6b, 6c et 6d. Dans une première étape représentée en figure 6a, l'élément de montage 17 est placé, selon une direction représentée par la flèche 49, au bord 28a de la surface 28 du support 23. Dans une deuxième étape représentée en figure 6b, l'élément de montage 17 est inséré par glissement dans les logements 31 et 33, selon une direction représentée par la flèche 51, jusqu'à ce que l'élément de guidage 27' soit en appui contre l'élément de butée 27c et que l'élément de guidage 29' soit en appui contre l'élément de butée 29c. Comme représenté en figure 6c, l'élément de montage 17 est alors en position déployée. Dans la position déployée, le logement semi-circulaire 41' est disposé en regard du logement semi-circulaire 41 et la butée 43' est disposée en face de la butée 43. Dans une dernière étape représentée en figure 6d, le ressort 39 est comprimé puis inséré dans les logements semi-circulaires 41, 41' par l'intermédiaire de l'ouverture d'insertion 45, selon une direction représentée par la flèche 53. Le ressort 39 se détend ensuite pour venir en appui contre les butées 43 et 43'.

Le support 23 comprend également sur une surface 55 opposée à la surface 25 et un élément de blocage 57 ayant une forme sensiblement similaire à la lettre « T ». L'élément de blocage 57 comprend une portion d'appui 57a et une portion de glissement 57b, destinées à coopérer avec le boîtier isolant 7 du contacteur 3.

Le dispositif de montage 21 est destiné à être monté sur un bord 59 du contacteur 3 comme représenté en figure 7.

Les étapes de montage du dispositif de montage 21 sur le contacteur 3 sont représentées en figures 8a, 8b et 8c.

Comme représenté en figure 8a, le boîtier isolant 7 comprend un emplacement 60 destiné à recevoir le dispositif de montage 21. L'emplacement 60 est délimité par deux éléments de guidage 60a et 60b, opposés l'un à l'autre, par deux éléments de butée 60c et 60d, par une surface 61 et par un élément de maintien 65, faisant saillie. Le boîtier isolant 7 comprend un logement 63 de retenue au niveau de l'emplacement 60, comprenant une portion d'insertion 63a et une partie d'appui 63b.

Au cours d'une première étape, le dispositif de montage 21 est placé dans l'emplacement 60, suivant une direction représentée par la flèche 67 en figure 8a, de manière à ce que la surface 55 du support 23 vienne en appui contre la surface 61 du boîtier isolant 7, et de manière à ce que l'élément de blocage 57 soit positionné en regard de la portion d'insertion 63a du logement 63. L'élément de blocage 57 s'insère dans la portion d'insertion 63a du logement 63 jusqu'à ce que la surface 55 soit en appui contre la surface 61. Comme représenté en figure 8b, le dispositif de montage 21 est alors en appui contre les éléments de guidage 60a et 60b et l'élément de maintien 65 se trouve disposé dans le logement 34c de l'élément élastique 34 du support 23.

Au cours d'une seconde étape, le dispositif de montage 21 est déplacé suivant une direction représentée par la flèche 69 en figure 8b. Le dispositif de montage 21 coulisse entre les éléments de guidage 60a et 60b et la portion de glissement 57b de l'élément de blocage 57 coulisse dans la partie d'appui 63b du logement 63, jusqu'à ce que le dispositif de montage 21 soit en appui contre les éléments de butée 60c et 60d du boîtier isolant 7. Les mouvements de translation suivant la direction y du dispositif de montage 21 par rapport au boîtier isolant 7 sont ainsi bloqués. La portion d'appui 57a de l'élément de blocage 57 est en butée contre la partie d'appui 63b du logement 63 et bloque les mouvements de translation du dispositif de montage 21 par rapport au boîtier isolant 7 suivant la direction z. Lors de ce déplacement du dispositif de protection selon la flèche 69, l'élément élastique 34 est soulevé manuellement suivant la direction z. Lorsque le dispositif de montage est en appui contre les portions de butée 60c et 60d, l'élément élastique 34 est relâché. L'élément de butée 34b est alors en regard de l'élément de maintien 65, et bloque les mouvements de translation du dispositif de montage 21 par rapport au boîtier isolant 7 suivant la direction - y.

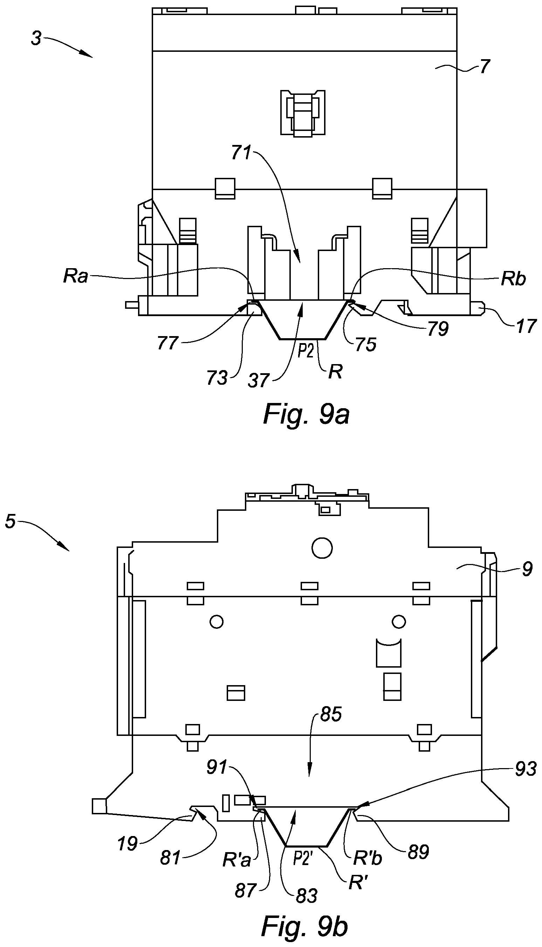

Le contacteur 3 comprend en outre un dispositif de fixation 71 représenté en figure 9a. Le dispositif de fixation 71 permet la fixation du contacteur 3 sur un rail R de manière indépendante, c'est-à-dire lorsqu'il n'est pas solidarisé à un disjoncteur. Le rail R est alors disposé dans une position relative individuelle P2 par rapport au contacteur 5. Le dispositif de fixation 71 est constitué de deux éléments de montage 73 et 75.

L'élément de montage 73 est mobile entre une position escamotée et une position déployée. En position déployée, l'élément de montage 73 et le boîtier isolant 7 définissent un logement 77 dans lequel est destiné à s'insérer un premier bord Ra du rail R.

L'élément de montage 75 est fixe et venu de matière avec le boîtier isolant 7. L'élément de montage 75 et le boîtier isolant 7 définissent un logement 79 dans lequel est destiné à s'insérer un second bord Rb du rail R.

Les éléments de montage 73 et 75 du dispositif de fixation 71 définissent un logement, formant la zone d'appui 37 du deuxième bord 13b du rail 13.

Comme représenté en figure 1, l'élément de montage 19 du disjoncteur 5 est venu de matière avec le boîtier isolant 9 et est fixe par rapport au boîtier isolant 9. Un logement 81 est défini entre l'élément de montage 19 et le boîtier isolant 9. Un premier bord 15a du rail 15 est destiné à s'insérer dans le logement 81. Un deuxième bord 15b du rail 15 est destiné à venir en appui contre le boîtier isolant 9 au niveau d'une zone d'appui 83. Le rail 15 est alors disposé suivant la position relative de fixation P1' par rapport au disjoncteur 5 à l'état assemblé.

Le disjoncteur 5 comprend en outre un dispositif de fixation 85 représenté en figure 9b. Le dispositif de fixation 85 permet la fixation du disjoncteur 5 sur un rail R' de manière indépendante, c'est-à-dire lorsqu'il n'est pas solidarisé à un contacteur. Le rail R' est alors disposé dans une position relative individuelle P2' par rapport au disjoncteur 5. Le dispositif de fixation 85 est constitué de deux éléments de montage 87 et 89.

L'élément de montage 87 est mobile entre une position escamotée et une position déployée. En position déployée, l'élément de montage 87 et le boîtier isolant 9 définissent un logement 91 dans lequel est destiné à s'insérer un premier bord R'a du rail R'.

L'élément de montage 89 est venu de matière avec le boîtier isolant 9 et est fixe par rapport au boîtier isolant 9. L'élément de montage 89 et le boîtier isolant 9 définissent un logement 93 dans lequel est destiné à s'insérer un second bord R'b du rail R'.

Les éléments de montage 87 et 89 du dispositif de fixation 85 définissent un logement, formant la zone d'appui 83 du deuxième bord 15b du rail 15.

Le dispositif de fixation du système de démarrage 1 sur les rails 13 et 15 comprend, en plus des éléments de montage 17 et 19, les zones d'appui 37 et 83 coopérant avec les deuxièmes portions 13b et 15b des rails 13 et 15 respectivement.

Bien entendu, la présente invention ne se limite pas au mode de réalisation décrit et représenté, fourni à titre d'exemple illustratif et non limitatif.

Par exemple, le dispositif de montage amovible pourrait être rapporté sur le disjoncteur de façon similaire.

Selon un mode de réalisation, le dispositif de montage pourrait être formé d'un bloc, sans qu'un opérateur puisse le démonter.

Selon un autre mode de réalisation, le dispositif de montage pourrait être fixé sur un boîtier isolant d'un appareil électrique de manière définitive.

## Revendications

1. Système de démarrage destiné à être rapporté sur une pluralité de rails de fixation (13, 15), le système de démarrage comprenant un premier appareil électrique (3), le premier appareil électrique (3) comprenant:
- un dispositif de montage (21) comprenant un support (23) comprenant au moins un élément de guidage (27, 29), un élément de blocage (57) et un élément élastique (34) comprenant une portion de butée (34b); un élément de montage (17) apte à occuper une position escamotée et une position déployée, agencé pour être guidé entre la position escamotée et la position déployée par l'au moins un élément de guidage (27, 29) ; un élément de rappel (39) agencé pour rappeler l'élément de montage (17) vers la position déployée ; en position déployée, l'élément de montage (17) forme un logement (35) avec le support (23) dans lequel est destinée à s'insérer une première portion (13a) d'un rail de fixation (13) parmi la pluralité de rails de fixation (13, 15) en définissant une position relative de fixation (P1) dudit rail de fixation (13) par rapport au premier appareil électrique (3) à l'état assemblé ;
- un boîtier isolant (7) solidaire du dispositif de montage (21) et comprenant une zone d'appui (37) destinée à coopérer avec une deuxième portion (13b) d'un rail de fixation (13) disposé selon la position relative de fixation (P1) par rapport à l'appareil électrique (3) à l'état assemblé ; un logement de retenue (63) comprenant une portion d'insertion (63a) de l'élément de blocage (57) du dispositif de montage (21) et une partie d'appui (63b) contre laquelle l'élément de blocage (57) du dispositif de montage (21) est en butée; un élément de maintien (65) coopérant avec la portion de butée (34b) de l'élément élastique (34) du dispositif de montage (21) ;
- un dispositif de fixation individuel (71) comprenant un premier élément de montage (75) individuel fixe formant avec le boîtier isolant (7) un premier logement (79) dans lequel est destinée à venir s'insérer la première portion (13a) du rail de fixation (13) en définissant une position relative de fixation individuelle (P2) dudit rail de fixation (13) par rapport à l'appareil électrique (3) ; un deuxième élément de montage (73) individuel mobile entre une position escamotée et une position déployée, et formant avec le boîtier isolant (7) un deuxième logement (77) lorsqu'il occupe la position déployée, dans lequel est destinée à venir s'insérer une deuxième portion (13b) du rail de fixation (13) disposé selon la position relative de fixation individuelle (P2) dudit rail de fixation (13) par rapport à l'appareil électrique (3) ; le dispositif de fixation individuel (71) comprend un logement d'appui défini entre le premier élément de montage (75) et le deuxième élément de montage (73), formant la zone d'appui (37) ;
le système de démarrage comprenant un deuxième appareil électrique (5) monté avec le premier appareil électrique (3) et relié électriquement au premier appareil électrique (3), le premier appareil électrique (3) et le second appareil électrique (5) étant alignés selon une première direction d'extension (D1) ; le premier appareil électrique (3) étant destiné à coopérer avec le premier rail de fixation (13) parmi la pluralité de rails de fixation (13, 15), disposé dans la position relative de fixation (P1) par rapport au premier appareil électrique (3) à l'état assemblé, le premier rail de fixation (13) s'étendant selon une deuxième direction d'extension (D2) transversale à la première direction d'extension (D1) ; le deuxième appareil électrique (5) étant destiné à coopérer avec un deuxième rail de fixation (15), dans une position relative de fixation (P1') par rapport au second appareil électrique (5) à l'état assemblé, le deuxième rail de fixation (15) s'étendant selon la deuxième direction d'extension (D2), et étant décalé par rapport au premier rail de fixation (13).

2. Système de démarrage selon la revendication 1, dans lequel l'élément de montage (17) comprend une portion de préhension (47).

3. Système de démarrage selon l'une des revendications 1 ou 2, dans lequel l'élément de blocage (57) comprend une portion d'appui (57a) destinée à coopérer avec le boîtier isolant (7).

4. Système de démarrage selon l'une des revendications précédentes, dans lequel l'élément élastique (34) comprend une portion plane (34a) et une ouverture (34c).

5. Système de démarrage selon la revendication 1, dans lequel la deuxième direction d'extension (D2) est orientée selon un angle compris entre 60° et 120° par rapport à la première direction d'extension (D1).

6. Système de démarrage selon l'une des revendications 1 ou 5, dans lequel le deuxième appareil électrique (5) comprend un deuxième boîtier isolant (9), le boîtier isolant du premier appareil électrique (3) étant appelé premier boîtier isolant (7), le deuxième appareil électrique (5) comprenant, en complément de l'élément de montage du premier appareil électrique à l'état assemblé, dit élément de montage primaire (17), un élément de montage secondaire (19) à l'état assemblé fixe formant avec le deuxième boîtier isolant (9) un logement secondaire (81) en complément du logement formé par l'élément de montage primaire (17) et le support (23), dit logement primaire (35),
le logement secondaire (81) étant destiné à recevoir une première portion (15a) du deuxième rail de fixation (15) dans la position relative de fixation (P1') du deuxième rail de fixation (15) par rapport au deuxième appareil électrique (5) à l'état assemblé,
le deuxième boîtier isolant (9) comprenant une deuxième zone d'appui (83) par similarité à la zone d'appui du premier boîtier isolant (7), dite première zone d'appui (37), au niveau de laquelle une deuxième portion (15b) du deuxième rail de fixation (15) est destinée à venir en appui dans la position relative de fixation (P1') du deuxième rail de support (15) par rapport au deuxième appareil électrique (5) à l'état assemblé.

7. Système de démarrage selon l'une des revendications 1, 5 ou 6, dans lequel le deuxième appareil électrique (5) comprend un deuxième dispositif de fixation (85) individuel, le dispositif de fixation individuel du premier appareil électrique (3) étant dit premier dispositif de fixation (71), le deuxième dispositif de fixation (85) comprenant :
- un troisième élément de montage (87) individuel mobile entre une position escamotée et une position déployée, et formant avec le deuxième boîtier isolant (9) un troisième logement (91) lorsqu'il occupe la position déployée, dans lequel est destinée à venir s'insérer la première portion (15a) d'un rail de fixation (15) dans une position relative de fixation individuelle (P2') dudit rail de fixation (15) par rapport au second appareil électrique (5) ;
- un quatrième élément de montage (89) fixe individuel formant avec le deuxième boîtier isolant (9) un quatrième logement (93) dans lequel est destinée à venir s'insérer la deuxième portion (15b) du rail de fixation (15) disposé dans la position relative de fixation individuelle (P2') dudit rail de fixation (15) par rapport au second appareil électrique (5).

8. Système de démarrage selon l'une des revendications 1, 5, 6 ou 7, dans lequel le deuxième dispositif de fixation (85) comprend un deuxième logement d'appui, le logement d'appui du premier dispositif de fixation (71) étant dit premier logement d'appui, le deuxième logement d'appui étant défini entre le troisième élément de montage (87) et le quatrième élément de montage (89) formant la deuxième zone d'appui (83).

## Patentansprüche

1. Startsystem, das dazu bestimmt ist, auf einer Vielzahl von Befestigungsschienen (13, 15) angebracht zu werden, wobei das Startsystem ein erstes elektrisches Gerät (3) umfasst, wobei das erste elektrische Gerät (3) umfasst:
- eine Montagevorrichtung (21), umfassend eine Halterung (23), umfassend mindestens ein Führungselement (27, 29), ein Blockierelement (57) und ein elastisches Element (34), umfassend einen Anschlagabschnitt (34b); ein Montageelement (17), das imstande ist, eine eingefahrene Position und eine ausgefahrene Position einzunehmen, angeordnet, um zwischen der eingefahrenen Position und der ausgefahrenen Position von dem mindestens einen Führungselement (27, 29) geführt zu werden; ein Rückstellelement (39), angeordnet, um das Montageelement (17) in die ausgefahrene Position zurückzustellen; wobei, in der ausgefahrenen Position, das Montageelement (17) eine Aufnahme (35) mit der Halterung (23) bildet, in die ein erster Abschnitt (13a) einer Befestigungsschiene (13) aus der Vielzahl von Befestigungsschienen (13, 15) bestimmt ist, eingefügt zu werden, indem eine relative Befestigungsposition (P1) der Befestigungsschiene (13) in Bezug auf das erste elektrische Gerät (3) in zusammengebautem Zustand definiert wird;
- einen Isolierkasten (7), der fest mit der Montagevorrichtung (21) verbunden ist und einen Auflagebereich (37) umfasst, der dazu bestimmt ist, mit einem zweiten Abschnitt (13b) einer Befestigungsschiene (13) zusammenzuwirken, die gemäß der relativen Befestigungsposition (P1) in Bezug auf das elektrische Gerät (3) in zusammengebautem Zustand angeordnet ist; eine Rückhalteaufnahme (63), umfassend einen Einfügeabschnitt (63a) des Blockierelements (57) der Montagevorrichtung (21) und einen Auflageteil (63b), gegen den das Blockierelement (57) der Montagevorrichtung (21) anschlägt; ein Halteelement (65), das mit dem Anschlagabschnitt (34b) des elastischen Elements (34) der Montagevorrichtung (21) zusammenwirkt;
- eine einzelne Befestigungsvorrichtung (71), umfassend ein festsitzendes, einzelnes erstes Montageelement (75), das mit dem Isolierkasten (7) eine erste Aufnahme (79) bildet, in die der erste Abschnitt (13a) der Befestigungsschiene (13) bestimmt ist, eingefügt zu werden, indem eine einzelne relative Befestigungsposition (P2) der Befestigungsschiene (13) in Bezug auf das elektrische Gerät (3) definiert wird; ein einzelnes zweites Montageelement (73), das zwischen einer eingefahrenen Position und einer ausgefahrenen Position beweglich ist und mit dem Isolierkasten (7) eine zweite Aufnahme (77) bildet, wenn es die ausgefahrene Position einnimmt, in die ein zweiter Abschnitt (13b) der Befestigungsschiene (13) bestimmt ist, eingefügt zu werden, die gemäß der einzelnen relativen Befestigungsposition (P2) der Befestigungsschiene (13) in Bezug auf das elektrische Gerät (3) angeordnet ist; wobei die einzelne Befestigungsvorrichtung (71) eine Auflageaufnahme umfasst, die zwischen dem ersten Montageelement (75) und dem zweiten Montageelement (73) definiert ist und den Auflagebereich (37) bildet;
wobei das Startsystem ein zweites elektrisches Gerät (5) umfasst, das mit dem ersten elektrischen Gerät (3) montiert ist und mit dem ersten elektrischen Gerät (3) elektrisch verbunden ist, wobei das erste elektrische Gerät (3) und das zweite elektrische Gerät (5) gemäß einer ersten Ausdehnungsrichtung (D1) ausgerichtet sind; wobei das erste elektrische Gerät (3) dazu bestimmt ist, mit der ersten Befestigungsschiene (13) aus der Vielzahl von Befestigungsschienen (13, 15) zusammenzuwirken, angeordnet in der relativen Befestigungsposition (P1) in Bezug auf das erste elektrische Gerät (3) in zusammengebautem Zustand, wobei sich die erste Befestigungsschiene (13) gemäß einer zweiten Ausdehnungsrichtung (D2) erstreckt, die quer zur ersten Ausdehnungsrichtung (D1) verläuft; wobei das zweite elektrische Gerät (5) dazu bestimmt ist, mit einer zweiten Befestigungsschiene (15) zusammenzuwirken, in einer relativen Befestigungsposition (P1') in Bezug auf das zweite elektrische Gerät (5) in zusammengebautem Zustand, wobei sich die zweite Befestigungsschiene (15) gemäß der zweiten Ausdehnungsrichtung (D2) erstreckt und in Bezug auf die erste Befestigungsschiene (13) versetzt ist.

2. Startsystem nach Anspruch 1, wobei das Montageelement (17) einen Greifabschnitt (47) umfasst.

3. Startsystem nach einem der Ansprüche 1 oder 2, wobei das Blockierelement (57) einen Auflageabschnitt (57a) umfasst, der dazu bestimmt ist, mit dem Isolierkasten (7) zusammenzuwirken.

4. Startsystem nach einem der vorstehenden Ansprüche, wobei das elastische Element (34) einen ebenen Abschnitt (34a) und eine Öffnung (34c) umfasst.

5. Startsystem nach Anspruch 1, wobei die zweite Ausdehnungsrichtung (D2) gemäß einem Winkel ausgerichtet ist, der zwischen 60° und 120° in Bezug auf die erste Ausdehnungsrichtung (D1) beträgt.

6. Startsystem nach einem der Ansprüche 1 oder 5, wobei das zweite elektrische Gerät (5) einen zweiten Isolierkasten (9) umfasst, wobei der Isolierkasten des ersten elektrischen Geräts (3) erster Isolierkasten (7) genannt wird, wobei das zweite elektrische Gerät (5) als Ergänzung zu dem Montageelement des ersten elektrischen Geräts in zusammengebautem Zustand, primäres Montageelement (17) genannt, ein festsitzendes sekundäres Montageelement (19) in zusammengebautem Zustand umfasst, das mit dem zweiten Isolierkasten (9) eine sekundäre Aufnahme (81) als Ergänzung zu der Aufnahme bildet, die von dem primären Montageelement (17) und der Halterung (23) gebildet wird, primäre Aufnahme (35) genannt,
wobei die sekundäre Aufnahme (81) dazu bestimmt ist, einen ersten Abschnitt (15a) der zweiten Befestigungsschiene (15) in der relativen Befestigungsposition (P1') der zweiten Befestigungsschiene (15) in Bezug auf das zweite elektrische Gerät (5) in zusammengebautem Zustand aufzunehmen,
wobei der zweite Isolierkasten (9) einen zweiten Auflagebereich (83) durch Ähnlichkeit mit dem Auflagebereich des ersten Isolierkastens (7), erster Auflagebereich (37) genannt, umfasst, auf dessen Höhe ein zweiter Abschnitt (15b) der zweiten Befestigungsschiene (15) dazu bestimmt ist, in der relativen Befestigungsposition (P1') der zweiten Halterungsschiene (15) in Bezug auf das zweite elektrische Gerät (5) in zusammengebautem Zustand dagegen zu drücken.

7. Startsystem nach einem der Ansprüche 1, 5 oder 6, wobei das zweite elektrische Gerät (5) eine einzelne zweite Befestigungsvorrichtung (85) umfasst, wobei die einzelne Befestigungsvorrichtung des ersten elektrischen Geräts (3) erste Befestigungsvorrichtung (71) genannt wird, wobei die zweite Befestigungsvorrichtung (85) umfasst:
- ein einzelnes drittes Montageelement (87), das zwischen einer eingefahrenen Position und einer ausgefahrenen Position beweglich ist und mit dem zweiten Isolierkasten (9) eine dritte Aufnahme (91) bildet, wenn es die ausgefahrene Position einnimmt, in der ein erster Abschnitt (15a) einer Befestigungsschiene (15) dazu bestimmt ist, in einer einzelnen relativen Befestigungsposition (P2') der Befestigungsschiene (15) in Bezug auf das zweite elektrische Gerät (5) eingefügt zu werden;
- ein einzelnes, festsitzendes viertes Montageelement (89), das mit dem zweiten Isolierkasten (9) eine vierte Aufnahme (93) bildet, in der der zweite Abschnitt (15b) der Befestigungsschiene (15) dazu bestimmt ist, eingefügt zu werden, die in der einzelnen relativen Befestigungsposition (P2') der Befestigungsschiene (15) in Bezug auf das zweite elektrische Gerät (5) angeordnet ist.

8. Startsystem nach einem der Ansprüche 1, 5, 6 oder 7, wobei die zweite Befestigungsvorrichtung (85) eine zweite Auflageaufnahme umfasst, wobei die Auflageaufnahme der ersten Befestigungsvorrichtung (71) erste Auflageaufnahme genannt wird, wobei die zweite Auflageaufnahme zwischen dem dritten Montageelement (87) und dem vierten Montageelement (89) definiert ist und den zweiten Auflagebereich (83) bildet.

## Claims

1. A starting system intended to be attached to a plurality of fastening rails (13, 15), the starting system comprising a first electrical apparatus (3), the first electrical apparatus (3) comprising:
- a mounting device (21) comprising a support (23) comprising at least one guide element (27, 29), a blocking element (57) and an elastic element (34) comprising a stop portion (34b); a mounting element (17) adapted to occupy a retracted position and a deployed position, arranged to be guided between the retracted position and the deployed position by the at least one guide element (27, 29); a return element (39) arranged to return the mounting element (17) towards the deployed position; in the deployed position, the mounting element (17) forms a housing (35) with the support (23) in which a first portion (13a) of a fastening rail (13) among the plurality fastening rails (13, 15) is intended to be inserted, by defining a relative fastening position (P1) of said fastening rail (13) with respect to the first electrical apparatus (3) in the assembled state;
- an insulating case (7) secured to the mounting device (21) and comprising a bearing area (37) intended to cooperate with a second portion (13b) of a fastening rail (13) disposed according to the relative fastening position (P1) with respect to the electrical apparatus (3) in the assembled state; a retaining housing (63) comprising an insertion portion (63a) of the blocking element (57) of the mounting device (21) and a bearing portion (63b) against which the blocking element (57) of the mounting device (21) abuts; a holding element (65) cooperating with the stop portion (34b) of the elastic element (34) of the mounting device (21);
- an individual fastening device (71) comprising a first fixed individual mounting element (75) forming, together with the insulating case (7), a first housing (79) into which the first portion (13a) of the fastening rail (13) is intended to be inserted, by defining an individual relative fastening position (P2) of said fastening rail (13) with respect to the electrical apparatus (3); a second individual mounting element (73) movable between a retracted position and a deployed position, and forming, together with the insulating case (7), a second housing (77) when it occupies the deployed position, in which a second portion (13b) of the fastening rail (13) disposed according to the individual relative fastening position (P2) of said fastening rail (13) is intended to be inserted with respect to the electrical apparatus (3); the individual fastening device (71) comprises a bearing housing defined between the first mounting element (75) and the second mounting element (73), forming the bearing area (37);
the starting system comprising a second electrical apparatus (5) mounted with the first electrical apparatus (3) and electrically connected to the first electrical apparatus (3), the first electrical apparatus (3) and the second electrical apparatus (5) being aligned in a first extension direction (D1); the first electrical apparatus (3) being intended to cooperate with the first fastening rail (13) among the plurality of fastening rails (13, 15), disposed in the relative fastening position (P1) with respect to the first electrical apparatus (3) in the assembled state, the first fastening rail (13) extending in a second extension direction (D2) transverse to the first extension direction (D1); the second electrical apparatus (5) being intended to cooperate with a second fastening rail (15), in a relative fastening position (P1') with respect to the second electrical apparatus (5) in the assembled state, the second fastening rail (15) extending in the second extension direction (D2), and being shifted with respect to the first fastening rail (13).

2. The starting system according to claim 1, wherein the mounting element (17) comprises a gripping portion (47).

3. The starting system according to any of claims 1 or 2, wherein the blocking element (57) comprises a bearing portion (57a) intended to cooperate with the insulating case (7).

4. The starting system according to any of the preceding claims, wherein the elastic element (34) comprises a planar portion (34a) and an opening (34c).

5. The starting system according to claim 1, wherein the second extension direction (D2) is oriented at an angle comprised between 60° and 120° with respect to the first extension direction (D1).

6. The starting system according to any of claims 1 or 5, wherein the second electrical apparatus (5) comprises a second insulating case (9), the insulating case of the first electrical apparatus (3) being called first insulating case (7), the second electrical apparatus (5) comprising, in addition to the mounting element of the first electrical apparatus in the assembled state, called primary mounting element (17), a secondary mounting element (19) in the fixed assembled state forming, together with the second insulating case (9), a secondary housing (81) in addition to the housing formed by the primary mounting element (17) and the support (23), called primary housing (35),
the secondary housing (81) being intended to receive a first portion (15a) of the second fastening rail (15) in the relative fastening position (P1') of the second fastening rail (15) with respect to the second electrical apparatus (5); in the assembled state,
the second insulating case (9) comprising a second bearing area (83) by matching with the bearing area of the first insulating case (7), called first bearing area (37), at the level of which a second portion (15b) of the second fastening rail (15) is intended to bear in the relative fastening position (P1') of the second support rail (15) with respect to the second electrical apparatus (5) in the assembled state.

7. The starting system according to any of claims 1, 5 or 6, wherein the second electrical apparatus (5) comprises a second individual fastening device (85), the individual fastening device of the first electrical apparatus (3) being called first fastening device (71), the second fastening device (85) comprising:
- a third individual mounting element (87) movable between a retracted position and a deployed position, and forming, together with the second insulating case (9), a third housing (91) when it occupies the deployed position, into which the first portion (15a) of a fastening rail (15) is intended to be inserted in an individual relative fastening position (P2') of said fastening rail (15) with respect to the second electrical apparatus (5);
- a fourth individual fixed mounting element (89) forming, together with the second insulating case (9), a fourth housing (93) into which the second portion (15b) of the fastening rail (15) disposed in the individual relative fastening position (P2') of said fastening rail (15) is intended to be inserted with respect to the second electrical apparatus (5).

8. The starting system according to any of claims 1, 5, 6 or 7, wherein the second fastening device (85) comprises a second bearing housing, the bearing housing of the first fastening device (71) being called first bearing housing, the second bearing housing being defined between the third mounting element (87) and the fourth mounting element (89) forming the second bearing area (83).
